(19) 

Europäisches
Patentamt
European
Patent Office
Office européen
des brevets

(11) **EP 4 289 986 A1**

(12) **EUROPEAN PATENT APPLICATION**
published in accordance with Art. 153(4) EPC

(43) Date of publication:
**13.12.2023 Bulletin 2023/50**

(21) Application number: **22749666.8**

(22) Date of filing: **31.01.2022**

(51) International Patent Classification (IPC):
**C22C 21/00** (2006.01)     **C22F 1/00** (2006.01)
**C22F 1/04** (2006.01)     **H01L 21/60** (2006.01)

(52) Cooperative Patent Classification (CPC):
**H01L 24/45; C22C 21/00; C22F 1/00; C22F 1/04;**
**H01L 21/60;** H01L 2224/45124

(86) International application number:
**PCT/JP2022/003599**

(87) International publication number:
**WO 2022/168794 (11.08.2022 Gazette 2022/32)**

(84) Designated Contracting States:
**AL AT BE BG CH CY CZ DE DK EE ES FI FR GB**
**GR HR HU IE IS IT LI LT LU LV MC MK MT NL NO**
**PL PT RO RS SE SI SK SM TR**
Designated Extension States:
**BA ME**
Designated Validation States:
**KH MA MD TN**

(30) Priority: **05.02.2021 JP 2021017062**

(71) Applicants:
• **Nippon Micrometal Corporation**
**Iruma-shi**
**Saitama 358-0032 (JP)**
• **NIPPON STEEL Chemical & Material Co., Ltd.**
**Tokyo 103-0027 (JP)**

(72) Inventors:
• **OYAMADA, Tetsuya**
**Tokyo 100-8071 (JP)**
• **SUTO, Yuya**
**Tokyo 100-8071 (JP)**
• **UNO, Tomohiro**
**Tokyo 100-8071 (JP)**
• **ODA, Daizo**
**Iruma-shi, Saitama 358-0032 (JP)**
• **OISHI, Ryo**
**Iruma-shi, Saitama 358-0032 (JP)**
• **KURIHARA, Yuto**
**Iruma-shi, Saitama 358-0032 (JP)**

(74) Representative: **Vossius & Partner**
**Patentanwälte Rechtsanwälte mbB**
**Siebertstraße 3**
**81675 München (DE)**

(54) **AL BONDING WIRE FOR SEMICONDUCTOR DEVICES**

(57)     To provide an Al bonding wire for semiconductor devices that stably exhibits a favorable bonding strength at a second bonded part. An Al bonding wire for semiconductor devices containing equal to or larger than 0.01 mass% and smaller than 0.8 mass% of one or more of Sc, Zr, and Mg in total, wherein, as a result of measuring a crystal orientation on a cross-section parallel to a wire axis direction including a wire axis of the bonding wire, an orientation ratio of a <100> crystal orientation angled at 15 degrees or less to the wire axis direction is equal to or higher than 30% and equal to or lower than 90%.

FIG. 1

PLANE B (CROSS SECTION PARALLEL TO WIRE AXIS DIRECTION INCLUDING WIRE AXIS)

AXIS A (WIRE CENTER AXIS)

**Description**

**TECHNICAL FIELD**

The present invention relates to an Al bonding wire for semiconductor devices.

**BACKGROUND ART**

In a semiconductor device, electrodes formed on a semiconductor chip are connected with a lead frame or electrodes on a substrate are connected via a bonding wire. In a power semiconductor device, the bonding wire made of aluminum (Al) as a material is mainly used. For example, Patent Literature 1 discloses an example of using an Al bonding wire with a diameter of 300 μm in a power semiconductor module. The power semiconductor device using the Al bonding wire is often used as semiconductor devices for large power equipment such as air conditioners or photovoltaic power generation systems, or on-vehicle semiconductor devices.

As a bonding process for the Al bonding wire, wedge bonding is used for both of first bonding with electrodes on a semiconductor chip and second bonding with the lead frames or electrodes on a substrate. The wedge bonding is a method of applying ultrasonic waves and a load to the bonding wire via a jig made of metal, breaking surface oxide films of a bonding wire material and an electrode material to expose new surfaces, and performing solid phase diffusion bonding. In leading-edge power semiconductor devices, the number of bonding wires is increasing as a rated current increases. When a bonding defect is caused such that the bonding wire peels off from the electrode at the time when the bonding is performed, a defect of a product or lowering of a manufacturing yield is caused, so that there is a demand for stably obtaining a favorable bonding strength at each bonded part. When using a material composed only of high-purity Al as the bonding wire in response to such a demand, the bonding wire is soft, so that the surface oxide film of the bonding wire or the substrate material cannot be sufficiently broken at the time of the second bonding in some cases, and it has been difficult to stably obtain a favorable bonding strength.

There has been developed a bonding wire made of a material obtained by adding a specific element to Al. Patent Literature 2 discloses that an Al bonding wire containing one or more of nickel (Ni), silicon (Si), and phosphorus (P), the amount of which is 800 ppm by weight or less in total, has a favorable bonding strength. Patent Literature 3 discloses a bonding wire the mechanical strength of which is improved by adding scandium (Sc) of 0.05 to 1% by weight to Al and using precipitation-strengthening.

**RELATED ART REFERENCE**

Patent Literature

[0005]

　　　Patent Literature 1: JP-A-2002-314038
　　　Patent Literature 2: JP-A-2016-152316
　　　Patent Literature 3: JP-A-2016-511529

**SUMMARY OF INVENTION**

**PROBLEM TO BE SOLVED BY THE INVENTION**

The Al bonding wire used for power semiconductor devices is required to stably exhibiting a favorable bonding strength at a second bonded part while achieving favorable electrical conductivity for efficiently sending an electric current, high long-term reliability of the bonded parts for enduring long-time use, a favorable bond quality at a first bonded part, and the like.

In the second bonding, a Cu substrate, an Al substrate, a substrate obtained by depositing Ni on a surface of an Al alloy, or the like is used as a substrate to be a bonding counterpart. Among these substrates, the substrate obtained by depositing Ni on the surface of the Al alloy is especially often used. A firm Ni oxide film is formed on a surface of Ni in the substrate obtained by depositing Ni on the surface of the Al alloy. There has been the problem that, when a bonding wire composed only of high-purity Al is bonded to this substrate, a sufficient bonding strength cannot be obtained at part of the bonded part, and a bonding defect is caused such that the Al bonding wire peels off from the substrate during bonding. Thus, there is a demand for developing an Al bonding wire that can stably exhibit a favorable bonding strength when bonding to the substrate obtained by depositing Ni on the surface of the Al alloy.

As described above, there are several reports on the Al bonding wire that is highly strengthened by adding another element to Al, but it has been difficult to stably obtain a favorable bonding strength at the second bonded part only by adding another element.

An object of the present invention is to provide an Al bonding wire for semiconductor devices that stably exhibits a favorable bonding strength at the second bonded part.

## MEANS FOR SOLVING PROBLEM

As a result of earnest investigation as to the problem described above, the present inventors have found that the problem described above can be solved by the Al bonding wire containing equal to or larger than 0.01 mass% and smaller than 0.8 mass% of one or more of Sc, Zr, and Mg in total, wherein, on a cross-section parallel to a wire axis direction thereof, an orientation ratio of a <100> crystal orientation angled at 15 degrees or less to the wire axis direction falls within a specific range, and further performed investigation based on such knowledge to complete the present invention.

That is, the summary of the present invention is as follows.

[1]. An Al bonding wire for semiconductor devices containing equal to or larger than 0.01 mass% and smaller than 0.8 mass% of one or more of Sc, Zr, and Mg in total, wherein, as a result of measuring a crystal orientation on a cross-section parallel to a wire axis direction including a wire axis of the bonding wire, an orientation ratio of a <100> crystal orientation angled at 15 degrees or less to the wire axis direction is equal to or higher than 30% and equal to or lower than 90%.

[2]. The Al bonding wire for semiconductor devices according to [1], further containing equal to or larger than 3 mass ppm and equal to or smaller than 500 mass ppm of one or more of Pd and Pt in total.

[3]. The Al bonding wire for semiconductor devices according to [1] or [2], further containing equal to or larger than 3 mass ppm and equal to or smaller than 100 mass ppm of Ni.

[4]. The Al bonding wire for semiconductor devices according to any one of [1] to [3], further containing equal to or larger than 3 mass ppm and equal to or smaller than 750 mass ppm of one or more of Fe and Si in total.

[5]. The Al bonding wire for semiconductor devices according to any one of [1] to [4], wherein a content of Al is equal to or larger than 98 mass%.

[6]. The Al bonding wire for semiconductor devices according to any one of [1] to [5], wherein a balance of the Al bonding wire comprises Al and inevitable impurities.

[7]. A semiconductor device comprising the Al bonding wire for semiconductor devices according to any one of [1] to [6] .

## EFFECT OF THE INVENTION

The present invention can provide an Al bonding wire for semiconductor devices that stably exhibits a favorable bonding strength at the second bonded part.

## BRIEF DESCRIPTION OF DRAWINGS

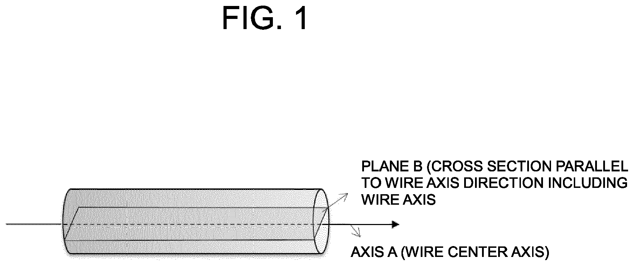

FIG. 1 is a schematic diagram for explaining a measurement target surface (inspection surface) at the time of measuring an orientation ratio of a <100> crystal orientation for an Al bonding wire.

## EMBODIMENT FOR CARRYING OUT THE INVENTION

Hereinafter, the present invention will be described in detail with reference to a preferable embodiment thereof. However, the present invention is not limited to the following embodiment and examples, and may be optionally changed to be implemented without departing from CLAIMS of the present invention and equivalents thereof.

[Al bonding wire for semiconductor devices]

An Al bonding wire for semiconductor devices according to the present invention is an Al bonding wire for semiconductor devices containing equal to or larger than 0.01 mass% and smaller than 0.8 mass% of one or more of Sc, Zr, and Mg in total, and is characterized in that, as a result of measuring a crystal orientation on a cross-section parallel to a wire axis direction including a wire axis of the bonding wire, an orientation ratio of a <100> crystal orientation angled at 15 degrees or less to the wire axis direction is equal to or higher than 30% and equal to or lower than 90%.

As described above, there has been the problem that a sufficient bonding strength cannot be obtained at part of a bonded part and a variation in the bonding strength is caused so that a bonding defect is caused such that the Al bonding wire peels off from the substrate during bonding when the bonding wire composed only of high-purity Al is bonded to a substrate on the surface of which a firm oxide film is formed such as a substrate obtained by depositing Ni on a surface of an Al alloy in the second bonding. Although there are several reports on the Al bonding wire that is highly strengthened by adding another element to Al, it has been difficult to solve the problem only by adding another element.

As a result of earnest investigation as to the problem described above, the present inventors have found that the Al bonding wire containing equal to or larger than 0.01 mass% and smaller than 0.8 mass% of one or more of Sc, Zr, and Mg in total, as well as an orientation ratio of a <100> crystal orientation angled at 15 degrees or less to the wire axis direction on a cross-section parallel to the wire axis direction is equal to or higher than 30% and equal to or lower than 90% may improve the bonding strength at a second bonded part and may reduce the variation in the bonding strength there. The Al bonding wire for semiconductor devices according to the present invention (hereinafter, also simply referred to as a "bonding wire" or a "wire") greatly contributes to achieving the bonding strength at the second bonded part and stability thereof required for leading-edge power semiconductor devices.

The reason why the bonding wire according to the present invention can stably exhibit a favorable bonding strength at the second bonded part is estimated as follows. As the bonding wire contains 0.01 mass% or more of one or more of Sc, Zr, and Mg in total, the wire is hardened, and a mechanical strength is increased. Due to such improvement in the mechanical strength, breaking of oxide films on a wire surface or an electrode surface is enabled and promoted at a second bonding step. On the other hand, by controlling, to be equal to or higher than 30%, the orientation ratio of the <100> crystal orientation angled at 15 degrees or less to the wire axis direction on the cross-section parallel to the wire axis direction of the bonding wire, influence of variation in the mechanical strength in the wire longitudinal direction caused by variation in the crystal orientation tends to be alleviated. It is estimated that the bonding wire of the present invention can stably exhibit a favorable bonding strength at the second bonded part because of a synergistic effect between such an effect of improving the mechanical strength and an effect of alleviating influence of variation in the mechanical strength in the wire longitudinal direction.

From the viewpoint of sufficiently breaking the oxide films on the wire surface and the electrode surface to obtain a favorable bonding strength at the second bonding step, a total concentration of one or more of Sc, Zr, and Mg in the bonding wire of the present invention is equal to or larger than 0.01 mass%, preferably equal to or larger than 0.02 mass%, more preferably equal to or larger than 0.04 mass% or equal to or larger than 0.05 mass%, and even more preferably equal to or larger than 0.06 mass%, equal to or larger than 0.08 mass%, equal to or larger than 0.1 mass%, equal to or larger than 0.12 mass%, equal to or larger than 0.14 mass%, or equal to or larger than 0.15 mass%. On the other hand, when the hardness of the bonding wire becomes excessive, a wire deformation amount at the time of the second bonding becomes insufficient under conditions for ultrasonic waves and loads that are typically used, and a favorable bonding strength is hardly obtained. From the viewpoint of obtaining a favorable bonding strength when performing the second bonding under typical conditions, the total concentration of one or more of Sc, Zr, and Mg in the bonding wire of the present invention is smaller than 0.8 mass%, preferably equal to or smaller than 0.79 mass%, more preferably equal to or smaller than 0.78 mass%, equal to or smaller than 0.76 mass%, or equal to or smaller than 0.75 mass%, and even more preferably equal to or smaller than 0.7 mass%, equal to or smaller than 0.65 mass%, equal to or smaller than 0.6 mass%, equal to or smaller than 0.55 mass%, or equal to or smaller than 0.5 mass%.

For concentration analysis of elements contained in the bonding wire, an Inductively Coupled Plasma (ICP) emission spectroscopic analysis device, or an ICP mass spectroscopic device can be used. In a case where elements derived from contaminants from the atmosphere such as oxygen or carbon are adsorbed by a surface of the bonding wire, it is effective to clean the surface by acid or alkali before the analysis is performed.

From the viewpoint of reducing influence of anisotropy of mechanical characteristics due to the crystal orientation and reducing variation in the wire deformation amount at the time of the second bonding to improve stability of the bonding strength, as a result of measuring the crystal orientation on the cross-section parallel to the wire axis direction including the wire axis of the bonding wire, the orientation ratio of the <100> crystal orientation angled at 15 degrees or less to the wire axis direction is equal to or higher than 30%, preferably equal to or higher than 40%, more preferably equal to or higher than 50%, and even more preferably equal to or higher than 55%, or equal to or higher than 60%. On the other hand, it has been found that the bonding strength at the second bonded part tends to be insufficient when the orientation ratio of the <100> crystal orientation is too high. Accordingly, the orientation ratio of the <100> crystal orientation is equal to or lower than 90%, preferably equal to or lower than 88%, and more preferably equal to or lower than 86%, equal to or lower than 85%, equal to or lower than 84%, equal to or lower than 82%, or equal to or lower than 80%.

The following describes a method for measuring the crystal orientation on the cross-section parallel to the wire axis direction including the wire axis of the bonding wire according to the present invention. As the method for measuring the crystal orientation, an Electron BackScattered Diffraction (EBSD) method can be used. A device used for the EBSD method is configured by a scanning electron microscope and a detector mounted thereon. The EBSD method is a method for determining the crystal orientation at each measurement point by projecting, on the detector, a diffraction pattern of a reflected electron that is generated when an electron beam is emitted to a sample, and analyzing the diffraction pattern. For analysis of data obtained by the EBSD method, dedicated software (OIM analysis and the like manufactured by TSL solutions) can be used. An orientation ratio of a specific crystal orientation can be calculated by using analysis software attached to the device assuming that the cross-section parallel to the wire axis direction including the wire axis (cross-section parallel to the bonding wire longitudinal direction) is an inspection surface. In the present invention, the wire axis of the bonding wire and the cross-section parallel to the wire axis direction including the wire axis will be described later with reference to FIG. 1 in a column of "(Measurement of orientation ratio of <100> crystal orientation)".

In the present invention, the orientation ratio of the <100> crystal orientation is defined as an area ratio of the <100> crystal orientation assuming that a measurement area is a population. In calculating the orientation ratio, the orientation ratio of the <100> crystal orientation was assumed to be an area ratio of the <100> crystal orientation that is calculated assuming that an area of only the crystal orientation identified based on certain reliability is a population in a measurement area. In a process of obtaining the orientation ratio, calculation was performed excluding a part in which the crystal orientation cannot be measured, a part in which the crystal orientation can be measured but reliability of orientation analysis is low, or the like.

In the present invention, the orientation ratio of the <100> crystal orientation was assumed to be an arithmetic mean of values of the orientation ratios obtained by measuring five or more points. In selecting a measurement region, it is preferable to ensure objectivity of measurement data by acquiring, from the bonding wire as a measurement target, a sample for measurement at intervals of 1 m or more with respect to the wire axis direction, for example. In the present invention, the measurement region for the crystal orientation by the EBSD method had a length equal to or larger than 300 $\mu$m and smaller than 600 um in the wire axis direction, and has a length larger than the entire wire in a direction perpendicular to the wire axis direction.

- Addition of Pd and Pt -

At a manufacturing step for the bonding wire, wire-drawing processing is performed. In the wire-drawing processing, scratches may be made on the surface of the bonding wire. The scratches on the surface of the bonding wire are made because part of the wire surface is shaved due to frictional force generated at a contact interface between the wire and dies when the wire passes through the dies at a wire-drawing step. The scratches on the surface of the Al bonding wire obviously impair external appearance of a product, and may cause deterioration of wedge bondability. Thus, there is a demand for reducing scratches on the wire surface and improving a surface property in manufacturing the Al bonding wire.

In a process of investigating the Al bonding wire containing equal to or larger than 0.01 mass% and smaller than 0.8 mass% of one or more of Sc, Zr, and Mg in total, wherein, on the cross-section parallel to the wire axis direction including the wire axis thereof, the orientation ratio of the <100> crystal orientation angled at 15 degrees or less to the wire axis direction is equal to or higher than 30% and equal to or lower than 90%, the present inventors have found that, if the Al bonding wire further contains equal to or larger than 3 mass ppm and equal to or smaller than 500 mass ppm of one or more of Pd and Pt in total, scratches on the wire surface can be reduced and the wire surface property may be improved.

The reason why scratches on the wire surface can be reduced by adding a predetermined amount of Pd and Pt to the bonding wire of the present invention is estimated as follows. That is, it may be because an effect of hardening the wire surface due to a predetermined amount of one or more of Sc, Zr, and Mg contained in the wire is synergistically enhanced by adding equal to or larger than 3 mass ppm and equal to or smaller than 500 mass ppm of one or more of Pd and Pt in total, and an effect of reducing variation of mechanical strength in the wire longitudinal direction and reducing variation of the frictional force on the interface between the wire and the dies during the wire-drawing processing is additionally exhibited due to the orientation ratio of the <100> crystal orientation equal to or higher than 30% and equal to or lower than 90% on the cross-section parallel to the wire axis direction. The reason why the wire surface is significantly hardened when the wire contains both of one or more of Sc, Zr, and Mg and one or more of Pd and Pt is not clear, but it can be considered that Sc, Zr, and Mg form a precipitated phase together with Pd and Pt in the vicinity of the wire surface, and the wire surface is hardened due to precipitation-strengthening.

From the viewpoint of sufficiently hardening the wire surface and improving the wire surface property in combination with one or more of Sc, Zr, and Mg, a total concentration of one or more of Pd and Pt contained in the bonding wire of the present invention is preferably equal to or larger than 3 mass ppm, more preferably equal to or larger than 5 mass ppm, and even more preferably equal to or larger than 10 mass ppm, equal to or larger than 12 mass ppm, equal to or larger than 14 mass ppm, equal to or larger than 15 mass ppm, equal to or larger than 16 mass ppm, equal to or larger than 18 mass ppm, or equal to or larger than 20 mass ppm. On the other hand, when the content of Pd and Pt is excessive, the wire surface is excessively hardened and the frictional force on the interface between the dies and the wire is increased, so that a sufficient improvement effect of the wire surface property cannot be obtained. Thus, the total concentration of one or more of Pd and Pt contained in the bonding wire of the present invention is preferably equal to or smaller than 500 mass ppm, more preferably equal to or smaller than 450 mass ppm, and even more preferably equal to or smaller than 400 mass ppm, equal to or smaller than 350 mass ppm, equal to or smaller than 300 mass ppm, equal to or smaller than 250 mass ppm, or equal to or smaller than 200 mass ppm.

- Ni -

The bonding wire of the present invention may further contain equal to or larger than 3 mass ppm and equal to or smaller than 100 mass ppm of Ni.

The present inventors have found that stability of the bonding strength at the second bonded part can be further improved when the bonding wire further contains equal to or larger than 3 mass ppm and equal to or smaller than 100 mass ppm of Ni. The reason for that is considered to be a synergistic effect of an effect of hardening the wire due to a predetermined amount of one or more of Sc, Zr, and Mg contained in the wire, and an effect such that variation of the mechanical strength in the wire longitudinal direction is reduced when crystal grains constituting the wire are made finer due to equal to or larger than 3 mass ppm and smaller than 100 mass ppm of Ni contained in the wire and a ratio of crystal grains having an isometric shape is increased.

From the viewpoint of further improving stability of the bonding strength at the second bonded part, a concentration of Ni contained in the bonding wire of the present invention is preferably equal to or larger than 3 mass ppm, more preferably equal to or larger than 5 mass ppm, and even more preferably equal to or larger than 10 mass ppm, equal to or larger than 15 mass ppm, equal to or larger than 20 mass ppm, or equal to or larger than 25 mass ppm. An upper limit of the concentration of Ni is preferably equal to or smaller than 100 mass ppm, more preferably equal to or smaller than 90 mass ppm, and even more preferably equal to or smaller than 80 mass ppm, equal to or smaller than 70 mass ppm, or equal to or smaller than 60 mass ppm.

- Fe, Si -

The bonding wire of the present invention may further contain equal to or larger than 3 mass ppm and equal to or smaller than 750 mass ppm of one or more of Fe and Si in total.

The wire surface property can be further improved when the wire further contains equal to or larger than 3 mass ppm and equal to or smaller than 750 mass ppm of one or more of Fe and Si in total especially in a case of containing equal to or larger than 3 mass ppm and equal to or smaller than 500 mass ppm of one or more of Pd and Pt in total. The reason for that is considered to be a synergistic effect of an effect such that the wire surface is significantly hardened when the wire contains both of one or more of Sc, Zr, and Mg and one or more of Pd and Pt, and an effect such that the crystal grains on the wire surface are made finer when the wire contains equal to or larger than 3 mass ppm and equal to or smaller than 750 mass ppm of one or more of Fe and Si in total.

From the viewpoint of further improving the wire surface property, a total concentration of one or more of Fe and Si contained in the bonding wire of the present invention is preferably equal to or larger than 3 mass ppm, more preferably equal to or larger than 5 mass ppm, and even more preferably equal to or larger than 6 mass ppm, equal to or larger than 8 mass ppm, equal to or larger than 10 mass ppm, equal to or larger than 12 mass ppm, equal to or larger than 14 mass ppm, or equal to or larger than 15 mass ppm. On the other hand, when the content of Fe and Si is excessive, the wire surface is excessively hardened and the frictional force on the interface between the dies and the wire is increased, so that a sufficient improvement effect for the wire surface property cannot be obtained. Thus, the total concentration of one or more of Fe and Si contained in the bonding wire of the present invention is preferably equal to or smaller than 750 mass ppm, more preferably equal to or smaller than 700 mass ppm, and even more preferably equal to or smaller than 600 mass ppm, equal to or smaller than 500 mass ppm, equal to or smaller than 400 mass ppm, equal to or smaller than 300 mass ppm, equal to or smaller than 250 mass ppm, or equal to or smaller than 200 mass ppm.

The balance of the bonding wire of the present invention contains Al. As an aluminum raw material for manufacturing the bonding wire, Al having a purity of 4N (Al: 99.99 mass% or more) can be used. More preferably, Al having a purity equal to or higher than 5N (Al: 99.999 mass% or more) is used. In a range of not inhibiting the effect of the present invention, the balance of the bonding wire according to the present invention may contain an element other than Al. The content of Al in the bonding wire according to the present invention is not limited so long as the content does not inhibit the effect of the present invention, and is preferably equal to or larger than 95 mass%, equal to or larger than 96 mass%, or equal to or larger than 97 mass%, and more preferably equal to or larger than 98 mass%, equal to or larger than 98.5 mass%, equal to or larger than 98.6 mass%, equal to or larger than 98.8 mass%, or equal to or larger than 99% by mass or more. According to a preferred embodiment, the balance of the bonding wire of the present invention consists of Al and inevitable impurities.

In a preferred embodiment, the bonding wire of the present invention does not have a coating that contains a metal other than Al as a main component on the outer periphery of the wire. Herein, the "coating that contains a metal other than Al as a main component" means the coating in which the content of the metal other than Al is 50 mass% or more.

The bonding wire of the present invention can stably exhibit a favorable bonding strength at the second bonded part while achieving favorable electrical conductivity, long-term reliability of the bonded part, a favorable bond quality at a first bonded part, and the like. Thus, the bonding wire of the present invention can be preferably used as an Al bonding wire for semiconductor devices, especially for power semiconductor devices.

A wire diameter of the bonding wire of the present invention is not particularly limited, but may be 50 to 600 um, for example.

(Method for manufacturing bonding wire)

The following describes an example of a manufacturing method for the bonding wire of the present invention. Al and an alloy element as raw materials preferably have high purity. Preferably, Al has a purity of 99.99 mass% or more and contains inevitable impurities as a balance. Preferably, Sc, Zr, Mg, Pd, Pt, Ni, Fe, and Si used as alloy elements each have a purity of 99.9 mass% or more and contain inevitable impurities as a balance. An Al alloy used for the bonding wire can be manufactured by loading a crucible made of alumina or graphite processed to obtain an ingot having a cylindrical shape with an Al raw material and a raw material of an alloy element, and melting the raw materials using an electric furnace or a high-frequency heating furnace. A diameter of the cylindrical ingot is preferably set to be smaller than $\Phi 8$ mm while taking into account workability at a subsequent processing step. An atmosphere in the furnace at the time of melting is preferably caused to be an inert atmosphere or a reducing atmosphere to prevent Al or other elements constituting the wire from being excessively oxidized. The highest end-point temperature of molten metal at the time of melting is preferably set to fall within a range of equal to or higher than 700°C and lower than 1080°C to prevent impurity elements from getting mixed in the molten metal from the crucible. As a cooling method after the melting, water cooling, oil cooling, furnace cooling, and the like can be used.

By performing wire-drawing processing with the dies on the cylindrical ingot obtained by melting, the wire having a desired wire diameter can be manufactured. At the time of wire-drawing processing, it is effective to use a lubricating liquid to secure lubricity at the contact interface between the wire and the dies. A reduction of area per die at the time of wire-drawing processing is preferably set to fall within a range of equal to or higher than 10.5% and smaller than 12.5%. Herein, assuming that the reduction of area per die is P1, P1 is represented by the following expression.

$$P1 = \{(R_2{}^2 - R_1{}^2)/R_2{}^2\} \times 100$$

In the expression, $R_2$ represents a diameter (mm) of the wire before processing, and $R_1$ represents a diameter (mm) of the wire after processing.

A wire feeding speed at the time of wire-drawing processing is preferably set to be equal to or higher than 20 m/minute and lower than 300 m/minute. The wire after the wire-drawing processing is preferably subjected to final heat treatment to finally have a breaking elongation equal to or larger than 12% and smaller than 25%. The final heat treatment can be performed by using a method of heating with a batch-type furnace for a certain time, or a method of performing the heat treatment while continuously sweeping the wire into a tubular furnace. An atmosphere during the final heat treatment is preferably caused to be an inert atmosphere or a reducing atmosphere. A heat treatment temperature of the final heat treatment is preferably set to be equal to or higher than 570°C and lower than 610°C, and a heat treatment time is preferably set to fall within a range of equal to or longer than 0.3 seconds and shorter than 3.5 seconds.

As a result of measuring the crystal orientation on the cross-section parallel to the wire axis direction including the wire axis of the bonding wire, to control the orientation ratio of the <100> crystal orientation angled at 15 degrees or less to the wire axis direction to be equal to or higher than 30% and equal to or lower than 90%, it is effective to perform intermediate heat treatment with a wire diameter before reaching the final wire diameter (hereinafter, referred to as an "intermediate wire diameter"). The following describes an example of an intermediate heat treatment method for controlling the orientation ratio of the <100> crystal orientation described above to fall within a range equal to or higher than 30% and equal to or lower than 90%, and conditions for the method.

For the intermediate heat treatment, a method of continuously sweeping the wire can be used. In a case of using this method, it is effective to perform the intermediate heat treatment multiple times with the wire diameter before reaching the final wire diameter at a temperature range equal to or higher than 550°C and lower than 600°C. It is effective to perform the intermediate heat treatment once with a wire diameter of 1.2 to 2.0 times the final wire diameter, once with a wire diameter of 2.2 to 3.0 times the final wire diameter, and once with a wire diameter of 3.5 to 5.5 times the final wire diameter. It is effective to set the heat treatment time at the time of intermediate heat treatment to be equal to or longer than 0.1 seconds and shorter than 3.2 seconds. An atmosphere of the intermediate heat treatment is preferably caused to be an inert atmosphere or a reducing atmosphere.

The following describes the reason why the method described above is effective to control the orientation ratio of the <100> crystal orientation described above to be equal to or higher than 30% and equal to or lower than 90%. A crystal grain having the <100> crystal orientation described above is formed in a process in which recrystallization is caused and crystal grains grow at the intermediate heat treatment step or at a final heat treatment step. Thus, it is important to control growth of the crystal grain by performing the intermediate heat treatment step with a predetermined wire diameter. Herein, the crystal grain grows using, as driving force, strain energy accumulated in a material due to wire-drawing processing, so that the intermediate heat treatment needs to be performed with the predetermined wire diameter. A growth rate of the crystal grain is increased as the heat treatment temperature is increased, so that it is important to control the heat treatment temperature or the heat treatment time. According to the present invention, it can be considered that growth of the crystal grain can be controlled by performing the intermediate heat treatment step with the predetermined wire diameter, and the orientation ratio of the <100> crystal orientation of the wire manufactured through the final heat treatment step can be controlled to be in a desired range.

[Semiconductor device]

The semiconductor device can be manufactured by connecting the electrode on the semiconductor chip to an external electrode on the lead frame or the substrate by using the bonding wire of the present invention.
In one embodiment, the semiconductor device of the present invention includes the circuit board, the semiconductor chip, and the bonding wire for bringing the circuit board and the semiconductor chip into conduction with each other, and is characterized in that the bonding wire is the bonding wire of the present invention.
In the semiconductor device of the present invention, the circuit board and the semiconductor chip are not particularly limited, and a known circuit board and semiconductor chip that may be used for constituting the semiconductor device may be used. Alternatively, a lead frame may be used in place of the circuit board. For example, like the semiconductor device disclosed in JP-A-2002-246542, the semiconductor device may include a lead frame and a semiconductor chip mounted on the lead frame.
Examples of the semiconductor device include various semiconductor devices used for electric products (for example, a computer, a cellular telephone, a digital camera, a television, an air conditioner, a solar power generation system), vehicles (for example, a motorcycle, an automobile, an electric train, a ship, and an aircraft), and the like, and a semiconductor device for electric power (power semiconductor device) is especially preferred.

**Examples**

Hereinafter, the present invention will be described in detail with reference to Examples. However, the present invention is not limited to the following Examples.

(Sample)

A method for producing a sample will be described. As a raw material, Al having a purity of 4N (99.99 mass% or more) and including inevitable impurities as a balance was used. Sc, Zr, Mg, Pd, Pt, Ni, Fe, and Si used as alloy elements each having a purity of 99.9 mass% or more and including inevitable impurities as a balance were also used. An Al alloy used for the bonding wire was manufactured by loading a graphite crucible with an Al raw material and a raw material of an alloy element, and melting them by using a high-frequency melting furnace. An atmosphere in the furnace at the time of melting was caused to be an Ar atmosphere, and the highest end-point temperature of molten metal at the time of melting was caused to be 750°C. A cooling method after the melting was furnace cooling.
A cylindrical ingot having a diameter of Φ6 mm was obtained by melting, and the wire-drawing processing and the intermediate heat treatment were performed on the ingot using dies to prepare the wire having a diameter of φ300 μm. At the time of wire-drawing processing, a commercially available lubricating liquid was used. A reduction of area per die at the time of wire-drawing processing was 11.0%. Conditions for the intermediate heat treatment were a temperature of 580°C and a time equal to or longer than 0.1 seconds and shorter than 3.2 seconds. The intermediate heat treatment was performed once with a wire diameter of 1.2 to 2.0 times the final wire diameter, once with a wire diameter of 2.2 to 3.0 times the final wire diameter, and once with a wire diameter of 3.5 to 5.5 times the final wire diameter. The wire feeding speed at the time of wire-drawing processing was set to be 25 m/minute. The wire after the wire-drawing processing was subjected to the final heat treatment to finally have a breaking elongation equal to or larger than 12% and smaller than 25%. The final heat treatment was performed while continuously sweeping the wire. The atmosphere during the final heat treatment was caused to be the Ar atmosphere. In the final heat treatment, the heat treatment temperature was set to be equal to or higher than 570°C and lower than 610°C, and the heat treatment time was set to be equal to or longer than 0.3 seconds and shorter than 3.5 seconds. In manufacturing the wires according to Comparative Examples 7, 9, and 11, the intermediate heat treatment temperature was set to be 540°C, and the heat treatment time was set to be 0.2 seconds. The intermediate heat treatment was performed once with a wire diameter of 450 μm, once with a wire diameter of 750 μm, and once with a wire diameter of 1500 um. In manufacturing the wires according to Comparative Examples 8, 10, and 12, the intermediate heat treatment temperature was set to be 620°C, and the heat treatment time was set to be 3.0 seconds. The intermediate heat treatment was performed once with a wire diameter

of 450 μm, once with a wire diameter of 750 μm, and once with a wire diameter of 1500 μm.

(Measurement of element content)

The content of elements in the bonding wire was measured by using ICP-OES ("PS3520UVDDII" manufactured by Hitachi High-Tech Corporation) or ICP-MS ("Agilent 7700x ICP-MS" manufactured by Agilent Technologies, Inc.) as an analysis device.

(Measurement of orientation ratio of <100> crystal orientation)

The orientation ratio of the <100> crystal orientation was measured by using, as an inspection surface, the cross-section parallel to the wire axis direction including the wire axis of the bonding wire. In the present invention, the wire axis means an axis A illustrated in FIG. 1, that is, a center axis of the bonding wire. Additionally, the cross-section parallel to the wire axis direction means a plane B illustrated in FIG. 1, that is, a cross-section parallel to the wire axis direction (wire longitudinal direction) including the center axis of the bonding wire. The EBSD method was used for measurement, and the orientation ratio of the <100> crystal orientation was calculated by using analysis software attached to the device through the procedure described above. Five measurement regions were selected at intervals of 1 m or more with respect to the wire axis direction, and an arithmetic mean of respective values of obtained orientation ratios is obtained to be the orientation ratio of the <100> crystal orientation.

(Method for evaluating bonding wire)

The following describes a method for evaluating the bonding wire. The wire diameter of the bonding wire used for evaluation was set to be φ300 μm. A semiconductor element made of Si was used, and as an electrode on the semiconductor element, used was an electrode obtained by depositing an alloy having a composition of Al-1%Si-0.5%Cu to have a thickness of 5 um. As a substrate, used was a substrate obtained by depositing 15 μm of Ni on an Al alloy. For bonding of the bonding wire, a commercially available wire bonder (manufactured by Ultrasonic Engineering Co., Ltd.) was used.

(A method for evaluating bonding strength at second bonded part)

A shear test was performed on 50 randomly selected second bonded parts to acquire bonding strengths, and an arithmetic mean bonding strength (F) and a population standard deviation (σ) were calculated. If F was smaller than 900 gf, it was determined that there is a practical problem and scored 0 points. If F was equal to or larger than 900 gf, it was determined that there is no practical problem and scored 1 point. Evaluation results are indicated in a column of "bonding strength at second bonded part (F)". 0 points mean "failure", and 1 point means "passed". Subsequently, if σ was equal to or larger than 80 gf, it was determined that there is a practical problem and scored 0 points. If σ was equal to or larger than 60 gf and smaller than 80 gf, it was determined that there is no practical problem and scored 1 point. If σ was equal to or larger than 50 gf and smaller than 60 gf, it was determined to be favorable and scored 2 points. If σ was equal to or larger than 40 gf and smaller than 50 gf, it was determined to be excellent and scored 3 points. If σ was smaller than 40 gf, it was determined to be particularly excellent and scored 4 points. Evaluation results are indicated in a column of "stability of bonding strength at second bonded part (σ)". 0 points mean "failure", and 1 or more points mean "passed".

(Method for evaluating wire surface property)

Ten samples each having a length of about 1 cm were taken from the wire at intervals of 30 cm with respect to the wire longitudinal direction. A wire surface of the taken sample was observed by a SEM with 100-fold magnification to examine whether a scratch is made. Among the observed 10 samples, if there were three or more samples in which a scratch was found on the wire surface, it was determined that there is a practical problem and scored 0 points. If there were two samples in which a scratch was found on the wire surface, it was determined that there is no practical problem and scored 1 point. If there was one sample in which a scratch was found on the wire surface, it was determined to be excellent and scored 2 points. If no scratch was found on wire surfaces of all of the samples, it was determined to be particularly excellent and scored 3 points. Evaluation results are indicated in a column of "wire surface property". 0 points mean "failure", and 1 or more points mean "passed".

The evaluation results of Examples and Comparative Examples are indicated in Table 1 and Table 2.

[Table 1]

(Table 1)

| No. | Sc, Zr, M concentration (mass%) | | | | Pd, Pt concentration (mass ppm) | | | Ni concentration (mass ppm) | Fe, Si concentration (mass ppm) | | | <Orientation ratio of <100> crystal orientation (%)*1 | Evaluation result | | |
|---|---|---|---|---|---|---|---|---|---|---|---|---|---|---|---|
| | Sc | Zr | Mg | Total | Pd | Pt | Total | | Fe | Si | Total | | Bonding strength at second bonded part (F) | Stability of bonding strength at second bonded part (σ) | Wire surface property |
| 1 | 0.01 | - | - | 0.01 | - | - | 0 | - | - | - | 0 | 90 | 1 | 3 | 1 |
| 2 | 0.15 | - | - | 0.15 | - | - | 0 | - | - | - | 0 | 78 | 1 | 3 | 1 |
| 3 | 0.20 | - | - | 0.20 | - | - | 0 | - | - | - | 0 | 75 | 1 | 3 | 1 |
| 4 | 0.25 | - | - | 0.25 | - | - | 0 | - | - | - | 0 | 74 | 1 | 3 | 1 |
| 5 | 0.30 | - | - | 0.30 | - | - | 0 | - | - | - | 0 | 60 | 1 | 3 | 1 |
| 8 | 0.79 | - | - | 0.79 | - | - | 0 | - | - | - | 0 | 33 | 1 | 1 | 1 |
| 7 | - | 0.01 | - | 0.01 | - | - | 0 | - | - | - | 0 | 80 | 1 | 3 | 1 |
| 8 | - | 0.15 | - | 0.15 | - | - | 0 | - | - | - | 0 | 85 | 1 | 3 | 1 |
| 9 | - | 0.30 | - | 0.30 | - | - | 0 | - | - | - | 0 | 58 | 1 | 2 | 1 |
| 10 | - | 0.35 | - | 0.35 | - | - | 0 | - | - | - | 0 | 48 | 1 | 2 | 1 |
| 11 | - | 0.78 | - | 0.78 | - | - | 0 | - | - | - | 0 | 33 | 1 | 1 | 1 |
| 12 | - | - | 0.01 | 0.01 | - | - | 0 | - | - | - | 0 | 87 | 1 | 3 | 1 |
| 13 | - | - | 0.20 | 0.20 | - | - | 0 | - | - | - | 0 | 78 | 1 | 3 | 1 |
| 14 | - | - | 0.40 | 0.40 | - | - | 0 | - | - | - | 0 | 56 | 1 | 2 | 1 |
| 15 | - | - | 0.80 | 0.80 | - | - | 0 | - | - | - | 0 | 47 | 1 | 2 | 1 |
| 18 | - | - | 0.79 | 0.79 | - | - | 0 | - | - | - | 0 | 38 | 1 | 1 | 1 |
| 17 | 0.14 | 0.05 | - | 0.19 | - | - | 0 | - | - | - | 0 | 83 | 1 | 3 | 1 |
| 18 | 0.23 | 0.10 | - | 0.33 | - | - | 0 | - | - | - | 0 | 78 | 1 | 3 | 1 |
| 19 | 0.30 | 0.20 | - | 0.50 | - | - | 0 | - | - | - | 0 | 57 | 1 | 2 | 1 |

EP 4 289 986 A1

| | No. | Sc, Zr, M concentration (mass%) | | | | Pd, Pt concentration (mass ppm) | | | Ni concentration (mass ppm) | Fe, Si concentration (mass ppm) | | | <Orientation ratio of <100> crystal orientation (%)*1 | Evaluation result | | |
|---|---|---|---|---|---|---|---|---|---|---|---|---|---|---|---|---|
| | | Sc | Zr | Mg | Total | Pd | Pt | Total | | Fe | Si | Total | | Bonding strength at second bonded part (F) | Stability of bonding strength at second bonded part (σ) | Wire surface property |
| Example | 20 | 0.14 | - | 0.04 | 0.18 | - | - | 0 | - | - | - | 0 | 82 | 1 | 3 | 1 |
| | 21 | 0.21 | - | 0.13 | 0.34 | - | - | 0 | - | - | - | 0 | 73 | 1 | 3 | 1 |
| | 22 | 0.32 | - | 0.19 | 0.51 | - | - | 0 | - | - | - | 0 | 58 | 1 | 2 | 1 |
| | 23 | - | 0.12 | 0.13 | 0.25 | - | - | 0 | - | - | - | 0 | 88 | 1 | 3 | 1 |
| | 24 | - | 0.22 | 0.23 | 0.45 | - | - | 0 | - | - | - | 0 | 73 | 1 | 3 | 1 |
| | 25 | - | 0.29 | 0.30 | 0.59 | - | - | 0 | - | - | - | 0 | 64 | 1 | 3 | 1 |
| | 28 | 0.08 | 0.08 | 0.05 | 0.21 | - | - | 0 | - | - | - | 0 | 80 | 1 | 3 | 1 |
| | 27 | 0.14 | 0.10 | 0.10 | 0.34 | - | - | 0 | - | - | - | 0 | 61 | 1 | 3 | 1 |
| | 28 | 0.25 | 0.15 | 0.15 | 0.55 | - | - | 0 | - | - | - | 0 | 42 | 1 | 2 | 1 |
| | 29 | 0.05 | - | - | 0.05 | 3 | - | 3 | - | - | - | 0 | 83 | 1 | 3 | 2 |
| | 30 | 0.10 | - | - | 0.10 | 27 | - | 27 | - | - | - | 0 | 80 | 1 | 3 | 2 |
| | 31 | 0.14 | - | - | 0.14 | 30 | - | 30 | - | - | - | 0 | 73 | 1 | 3 | 2 |
| | 32 | 0.20 | - | - | 0.20 | 35 | - | 35 | - | - | - | 0 | 71 | 1 | 3 | 2 |
| | 33 | 0.26 | - | - | 0.26 | 28 | - | 28 | - | - | - | 0 | 82 | 1 | 3 | 2 |
| | 34 | 0.25 | - | - | 0.25 | - | 70 | 70 | - | - | - | 0 | 75 | 1 | 3 | 2 |
| | 35 | 0.28 | - | - | 0.28 | - | 495 | 495 | - | - | - | 0 | 72 | 1 | 3 | 2 |
| | 38 | 0.06 | - | - | 0.06 | - | 2 | 2 | - | - | - | 0 | 87 | 1 | 3 | 1 |
| | 37 | 0.10 | - | - | 0.10 | - | 35 | 35 | - | - | - | 0 | 82 | 1 | 3 | 2 |
| | 38 | 0.15 | - | - | 0.15 | - | 44 | 44 | - | - | - | 0 | 79 | 1 | 3 | 2 |
| | 39 | 0.20 | - | - | 0.20 | - | 35 | 35 | - | - | - | 0 | 72 | 1 | 3 | 2 |

(continued)

| No. | Sc, Zr, M concentration (mass%) | | | | Pd, Pt concentration (mass ppm) | | | Ni concentration (mass ppm) | Fe, Si concentration (mass ppm) | | | <Orientation ratio of <100> crystal orientation (%)[1] | Evaluation result | | |
|---|---|---|---|---|---|---|---|---|---|---|---|---|---|---|---|
| | Sc | Zr | Mg | Total | Pd | Pt | Total | | Fe | Si | Total | | Bonding strength at second bonded part (F) | Stability of bonding strength at second bonded part ($\sigma$) | Wire surface property |
| 40 | 0.24 | - | - | 0.24 | - | 29 | 29 | - | - | - | 0 | 71 | 1 | 3 | 2 |

[1] As a result of measuring crystal orientation on cross-section parallel to wire axis direction including wire axis of bonding wire, orientation ratio of <100> crystal orientation angled at 15 degrees or less to wire axis direction (%)

[Table 2]

(Table 2)

| | No. | Sc, Zr, M concentration (mass%) | | | | Pd, Pt concentration (mass ppm) | | | Ni concentration (mass ppm) | Fe, Si concentration (mass ppm) | | | Orientation ratio of <100> crystal orientation (%)*1 | Evaluation result | | |
| --- | --- | --- | --- | --- | --- | --- | --- | --- | --- | --- | --- | --- | --- | --- | --- | --- |
| | | Sc | Zr | Mg | Total | Pd | Pt | Total | | Fe | Si | Total | | Bonding strength at second bonded part (F) | Stability of bonding strength at second bonded part (σ) | Wire surface property |
| Example | 41 | 0.25 | - | - | 0.25 | - | 500 | 500 | - | - | - | 0 | 88 | 1 | 3 | 1 |
| | 42 | 0.25 | - | - | 0.25 | - | 510 | 510 | - | - | - | 0 | 87 | 1 | 3 | 1 |
| | 43 | 0.20 | - | - | 0.20 | 20 | 35 | 55 | - | - | - | 0 | 74 | 1 | 3 | 2 |
| | 44 | 0.12 | 0.07 | - | 0.19 | 35 | - | 35 | - | - | - | 0 | 77 | 1 | 3 | 2 |
| | 45 | 0.26 | 0.14 | - | 0.40 | 25 | - | 25 | - | - | - | 0 | 71 | 1 | 3 | 2 |
| | 46 | 0.30 | 0.21 | - | 0.51 | - | 45 | 45 | - | - | - | 0 | 87 | 1 | 3 | 2 |
| | 47 | 0.11 | - | 0.15 | 0.28 | 39 | - | 39 | - | - | - | 0 | 78 | 1 | 3 | 2 |
| | 48 | 0.26 | - | 0.20 | 0.48 | 38 | - | 38 | - | - | - | 0 | 89 | 1 | 3 | 2 |
| | 49 | 0.28 | - | 0.10 | 0.38 | - | 51 | 51 | - | - | - | 0 | 66 | 1 | 3 | 2 |
| | 50 | 0.12 | - | - | 0.12 | 10 | - | 10 | 35 | - | - | 0 | 79 | 1 | 4 | 2 |
| | 51 | 0.25 | - | - | 0.25 | - | - | 0 | 25 | - | - | 0 | 74 | 1 | 4 | 1 |
| | 52 | - | 0.13 | - | 0.13 | 11 | - | 11 | 54 | - | - | 0 | 78 | 1 | 4 | 2 |
| | 53 | - | 0.24 | - | 0.24 | - | 58 | 58 | 45 | - | - | 0 | 71 | 1 | 4 | 2 |
| | 54 | - | - | 0.16 | 0.18 | 10 | - | 10 | 100 | - | - | 0 | 83 | 1 | 4 | 2 |
| | 55 | - | - | 0.24 | 0.24 | - | - | 0 | 3 | - | - | 0 | 73 | 1 | 4 | 1 |
| | 58 | 0.15 | - | - | 0.15 | 30 | - | 30 | - | 5 | 13 | 18 | 78 | 1 | 3 | 3 |
| | 57 | 0.25 | - | - | 0.25 | 50 | - | 50 | - | - | 15 | 15 | 68 | 1 | 3 | 3 |
| | 58 | - | 0.18 | - | 0.18 | - | 50 | 50 | - | 25 | - | 25 | 77 | 1 | 3 | 3 |
| | 59 | - | 0.25 | - | 0.25 | - | 80 | 80 | - | - | 746 | 748 | 85 | 1 | 3 | 3 |

14

EP 4 289 986 A1

(continued)

| | No. | Sc, Zr, M concentration (mass%) | | | | Pd, Pt concentration (mass ppm) | | | Ni concentration (mass ppm) | Fe, Si concentration (mass ppm) | | | Orientation ratio of <100> crystal orientation (%)*1 | Evaluation result | | |
|---|---|---|---|---|---|---|---|---|---|---|---|---|---|---|---|---|
| | | Sc | Zr | **Mg** | Total | Pd | Pt | Total | | Fe | Si | Total | | Bonding strength at second bonded part (F) | Stability of bonding strength at second bonded part ($\sigma$) | Wire surface property |
| | 60 | - | - | 0.18 | 0.18 | 20 | - | 20 | - | - | 35 | 35 | 78 | 1 | 3 | 3 |
| | 61 | - | - | 0.78 | 0.78 | - | 30 | 30 | - | - | 755 | 755 | 38 | 1 | 1 | 2 |
| Comparative Example | 1 | 0.009 | | | 0.009 | - | - | 0 | - | - | - | 0 | 30 | 0 | 1 | 1 |
| | 2 | 0.8 | | | 0.8 | - | - | 0 | - | - | - | 0 | 90 | 0 | 1 | 1 |
| | 3 | | 0.009 | | 0.009 | - | - | 0 | - | - | - | 0 | 60 | 0 | 1 | 1 |
| | 4 | | 0.8 | | 0.8 | - | - | 0 | - | - | - | 0 | 70 | 0 | 1 | 1 |
| | 5 | | | 0.009 | 0.009 | - | - | 0 | - | - | - | 0 | 80 | 0 | 1 | 1 |
| | 6 | | | 0.8 | 0.8 | - | - | 0 | - | - | - | 0 | 60 | 0 | 1 | 1 |
| | 7 | 0.8 | | | 0.6 | - | - | 0 | - | - | - | 0 | 29 | 1 | 0 | 1 |
| | 8 | 0.8 | | | 0.6 | - | - | 0 | - | - | - | 0 | 91 | 0 | 1 | 1 |
| | 9 | | 0.8 | | 0.6 | - | - | 0 | - | - | - | 0 | 29 | 1 | 0 | 1 |
| | 10 | | 0.8 | | 0.6 | - | - | 0 | - | - | - | 0 | 91 | 0 | 1 | 1 |
| | 11 | | | 0.6 | 0.6 | - | - | 0 | - | - | - | 0 | 29 | 1 | 0 | 1 |
| | 12 | | | 0.6 | 0.6 | - | - | 0 | - | - | - | 0 | 91 | 0 | 1 | 1 |

*1 As a result of measuring crystal orientation on cross-section parallel to wire axis direction including wire axis of bonding wire, orientation ratio of <100> crystal orientation angled at 15 degrees or less to wire axis direction (%)

EP 4 289 986 A1

15

It was confirmed that all of the wires in Examples No. 1 to 61 contain equal to or larger than 0.01 mass% and smaller than 0.8 mass% of one or more of Sc, Zr, and Mg the amount of which is in total, the orientation ratio of the <100> crystal orientation angled at 15 degrees or less to the wire axis direction is equal to or higher than 30% and equal to or lower than 90% on the cross-section parallel to the wire axis direction including the wire axis, and the bonding strength at the second bonded part and stability thereof are favorable.

Additionally, it was confirmed that, with the wires in Examples No. 29 to 35, 37 to 41, 43 to 50, 52 to 54, and 56 to 61 each containing equal to or larger than 3 mass ppm and equal to or smaller than 500 mass ppm of one or more of Pd and Pt in total, scratches on the wire surface can be reduced and the wire surface property can be improved.

It was also confirmed that, with the wires in Examples No. 50 to 55 each containing equal to or larger than 3 mass ppm and equal to or smaller than 100 mass ppm of Ni, stability of the bonding strength at the second bonded part can be further improved.

Furthermore, it was confirmed that, with the wires in Examples No. 56 to 60 each containing equal to or larger than 3 mass ppm and equal to or smaller than 750 mass ppm of one or more of Fe and Si in total, scratches on the wire surface can be further reduced, and the wire surface property can be further improved.

On the other hand, it was confirmed that, with the wires in Comparative Examples No. 1 to 12, the total concentration of one or more of Sc, Zr, and Mg or the orientation ratio of the <100> crystal orientation is outside the range of the present invention, and the bonding strength at the second bonded part cannot be stably exhibited.

## Claims

1.  An Al bonding wire for semiconductor devices containing equal to or larger than 0.01 mass% and smaller than 0.8 mass% of one or more of Sc, Zr, and Mg in total, wherein, as a result of measuring a crystal orientation on a cross-section parallel to a wire axis direction including a wire axis of the bonding wire, an orientation ratio of a <100> crystal orientation angled at 15 degrees or less to the wire axis direction is equal to or higher than 30% and equal to or lower than 90%.

2.  The Al bonding wire for semiconductor devices according to claim 1, further containing equal to or larger than 3 mass ppm and equal to or smaller than 500 mass ppm of one or more of Pd and Pt in total.

3.  The Al bonding wire for semiconductor devices according to claim 1 or 2, further containing equal to or larger than 3 mass ppm and equal to or smaller than 100 mass ppm of Ni.

4.  The Al bonding wire for semiconductor devices according to any one of claims 1 to 3, further containing equal to or larger than 3 mass ppm and equal to or smaller than 750 mass ppm of one or more of Fe and Si in total.

5.  The Al bonding wire for semiconductor devices according to any one of claims 1 to 4, wherein a content of Al is equal to or larger than 98 mass%.

6.  The Al bonding wire for semiconductor devices according to any one of claims 1 to 5, wherein a balance of the Al bonding wire comprises Al and inevitable impurities.

7.  A semiconductor device comprising the Al bonding wire for semiconductor devices according to any one of claims 1 to 6.

# FIG. 1

PLANE B (CROSS SECTION PARALLEL TO WIRE AXIS DIRECTION INCLUDING WIRE AXIS

AXIS A (WIRE CENTER AXIS)

## INTERNATIONAL SEARCH REPORT

| | International application No. |
|---|---|
| | **PCT/JP2022/003599** |

**A. CLASSIFICATION OF SUBJECT MATTER**

***C22C 21/00***(2006.01)i; ***C22F 1/00***(2006.01)i; ***C22F 1/04***(2006.01)i; ***H01L 21/60***(2006.01)i

FI: H01L21/60 301F; C22C21/00 A; C22F1/00 606; C22F1/00 625; C22F1/00 630C; C22F1/00 661A; C22F1/00 681; C22F1/00 685Z; C22F1/00 694Z; C22F1/00 630K; C22F1/00 686A; C22F1/00 691B; C22F1/00 691C; C22F1/00 691Z; C22F1/00 694A; C22F1/00 673; C22F1/00 674; C22F1/00 692A; C22F1/00 682; C22F1/04 D

According to International Patent Classification (IPC) or to both national classification and IPC

**B. FIELDS SEARCHED**

Minimum documentation searched (classification system followed by classification symbols)

C22C21/00; C22F1/00; C22F1/04; H01L21/60

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2020-59882 A (NIPPON MICROMETAL CORP) 16 April 2020 (2020-04-16) paragraphs [0008], [0011]-[0042], tables 1-2 | 1-7 |
| A | JP 2016-511529 A (HERAEUS DEUTSCHLAND GMBH & CO. KG) 14 April 2016 (2016-04-14) paragraphs [0001], [0019]-[0073], fig. 1-2, tables 1-2 | 1-7 |
| A | JP 2014-47417 A (TANAKA ELECTRONICS IND CO LTD) 17 March 2014 (2014-03-17) paragraphs [0001], [0010]-[0020], table 1 | 1-7 |
| A | WO 2020/184655 A1 (NIPPON MICROMETAL CORP) 17 September 2020 (2020-09-17) paragraphs [0008]-[0043], tables 1-2 | 1-7 |
| A | JP 2018-70915 A (YAZAKI CORP) 10 May 2018 (2018-05-10) paragraphs [0009]-[0058], fig. 1-2, table 1 | 1-7 |

☐ Further documents are listed in the continuation of Box C.    ☑ See patent family annex.

| | |
|---|---|
| \* Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **22 March 2022** | **29 March 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2022/003599**

| Patent document cited in search report | | | Publication date (day/month/year) | Patent family member(s) | Publication date (day/month/year) |
|---|---|---|---|---|---|
| JP | 2020-59882 | A | 16 April 2020 | (Family: none) | |
| JP | 2016-511529 | A | 14 April 2016 | US 2015/0303165 A1 paragraphs [0006], [0023]-[0076], fig. 1-2, tables 1-2 WO 2014/079726 A1 EP 2736047 A1 KR 10-2015-0090132 A CN 104937672 A | |
| JP | 2014-47417 | A | 17 March 2014 | KR 10-1307022 B1 paragraphs [0001], [0012]-[0017], table 1 CN 103320654 A | |
| WO | 2020/184655 | A1 | 17 September 2020 | (Family: none) | |
| JP | 2018-70915 | A | 10 May 2018 | US 2018/0114606 A1 paragraphs [0009]-[0065], fig. 1-2, table 1 CN 107978382 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002314038 A
- JP 2016152316 A
- JP 2016511529 A
- JP 2002246542 A